# EUROPEAN PATENT SPECIFICATION

(11) **EP 1 078 426 B1**
(45) Date of publication and mention of the grant of the patent: **24.11.2004**
(21) Application number: 00905061.8
(22) Date of filing: 14.02.2000
(51) Int. Cl.: H01R 13/24, H05K 7/12, H05K 3/32, G02F 1/13

(54) **DISPLAY DEVICE**
ANZEIGEVORRICHTUNG
DISPOSITIF D'AFFICHAGE

(30) Priority: 09.03.1999 EP 99200696
(43) Date of publication of application: 28.02.2001
(73) Proprietor: Koninklijke Philips Electronics N.V., 5621 BA Eindhoven (NL)
(72) Inventor: TRIEPELS, Jozeph, W., NL-5656 AA Eindhoven (NL); KUSTERS, Roel, H., L., NL-5656 AA Eindhoven (NL); VERWEG, Fransiscus, G., C., NL-5656 AA Eindhoven (NL); HANDELS, Henri, S., A., NL-5656 AA Eindhoven (NL); BACHUS, Marcel, S., B., NL-5656 AA Eindhoven (NL); SCHEUERMANN, Johannes, W., J., M., NL-5656 AA Eindhoven (NL)
(74) Representative: Raap, Adriaan Yde
(86) International application number: PCT/EP2000/001175
(87) International publication number: WO 2000/054373

(56) References cited:
- EP-A- 0 795 868
- EP-A- 0 867 979
- WO-A-97/01791
- GB-A- 2 278 947
- US-A- 3 904 934
- US-A- 4 012 117
- US-A- 5 066 235
- US-A- 5 455 409
- US-A- 5 579 528
- US-A- 5 834 753
- PATENT ABSTRACTS OF JAPAN vol. 016, no. 424 (P-1415), 7 September 1992 (1992-09-07) & JP 04 143732 A (ALPS ELECTRIC CO LTD), 18 May 1992 (1992-05-18)
- PATENT ABSTRACTS OF JAPAN vol. 014, no. 558 (P-1141), 12 December 1990 (1990-12-12) -& JP 02 239232 A (ALPS ELECTRIC CO LTD), 21 September 1990 (1990-09-21)

## Description

The invention relates to a display device comprising a first substrate having a conductor pattern for connecting pixels in an electrically conducting manner, parts of which are connected in an electrically conducting manner to connection tracks on a support.

Display devices of this type, particularly liquid crystal display devices, are used very generally in, for example, measuring apparatus, but also in, for example, portable telephones. Moreover, electroluminescent display devices, based on (organic) LEDs find an increasingly wider application.

A display device of the type mentioned above is described in USP 4.012.117. In the embodiment shown the patterns on a first substrate, which comprise picture electrodes, are interconnected to connection tracks provided on a support. The support in this case is a carrier having a cavity in which cavity an integrated circuit (chip) is provided. Terminals on the chip (integrated circuit) are interconnected to conducting paths on the support by fine wirings. Interconnection of the conducting paths to a printed circuit board occurs via pins which are inserted into holes in said printed circuit board.

With the ever increasing miniaturization of electronics, it is necessary to realize an ever increasing number of drive electronics on the first substrate. On the other hand, there is a tendency to manufacture the actual display panel (display section) as a standard component. If such a standard component is mounted in a apparatus, for example, by soldering on the support (for example, a printed circuit board or another type of substrate provided with conducting (connection) tracks), or by clamping, stringent requirements are imposed on the contacts (low resistance, mechanical stability, etc.). To this end, contact paste is often used between the conductor pattern and further contact elements, such as connectors in connector housings, contact pins, etc. In addition, notably the tolerances of connection tracks to be connected on the support may become very strict with respect to the associated parts of the conductor pattern.

It is, inter alia, an object of the invention to provide a display device of the type described above in which the resistance is as low as possible while connection conductors on the surface area of the first substrate are connected in a reliable manner to connection tracks on the support.

To this end, the invention is characterized according to the characterizing part of claim 1. Especially since each metal of the metal-metal contact is chosen from the group of gold, silver and nickel. Since these metals are not attacked or are hardly attacked or oxidized, a pressure contact is sufficient in the final assembly.

The metal-metal contact is preferably a gold-gold contact.

A first embodiment of a display device according to the invention is characterized in that the conducting connection between at least a part of the conductor pattern and a connection track comprises a resilient conductor.

Since a satisfactorily conducting material (for example, gold) is chosen for the resilient conductor, the resistance of the contact between the conductor pattern and the connection track is negligible.

In this connection, a resilient conductor is understood to be any conductor in which, by compression of the conductor between two conducting faces, an electrically conducting contact between the two faces is obtained or maintained. Examples are so-called pogopins as described in, for example, USP 5,157,325 and JP-A-4-22077, but also the pins as described in USP 5,500,606 are possible. A possible conducting paste between the resilient conductor and the conductor track, which is cured by UV radiation, can now be dispensed with. This reduces the number of mounting steps (providing the paste, curing) for the end user (or the final assembly) where only mechanical handling is preferably performed.

A further embodiment of a display device according to the invention is characterized in that the conducting connection between the resilient conductor and the part of the conductor pattern comprises an anisotropically conducting foil.

This embodiment has the advantage that the foil can extend across the first substrate as far as, for example, the contacts of (drive) ICs. The conductance between the contact and the connection of the IC now takes place via the conductor of the foil (for example, copper tracks) so that a more low-ohmic connection is realized.

The invention is notably suitable for a display device in which the conductor pattern is present on the support-facing side of the first substrate.

The conductor pattern may be alternatively present on the other side of the substrate. Such a display device is characterized in that conductors associated with the conductor pattern extend as far as proximate to an edge of the first substrate, a conductor part associated with the electrically conducting connection between the connection track and the part of the conductor pattern enclosing the edge at the area of said edge.

The invention is applicable to display devices based on liquid crystal effects or other electro-optical effects, in which an electro-optical material is present between two substrates. Such an embodiment is characterized in that the display device comprises a second substrate and an electro-optical material between the two substrates, each being provided with picture electrodes which define pixels with the interpositioned electro-optical material, the first substrate being provided with the conductor pattern beyond the part of the first substrate located opposite the second substrate. The display device may also be based on an electroluminescent effect.

The resilient conductor may alternatively contact the support on the side remote from the first substrate. Such a display device is characterized in that at least one resilient conductor contacts a conductor pattern on the side of the support remote from the first. substrate.

These and other aspects of the invention are apparent from and will be elucidated with reference to the embodiment(s) described hereinafter.

In the drawings:
Fig. 1 is a diagrammatic cross-section of a part of a first embodiment of a display device according to the invention,
Fig. 2 is a diagrammatic cross-section taken on the line II-II in Fig. 1,
Fig. 3 shows a variant of the connection shown in Fig. 2, while
Fig. 4 is a diagrammatic cross-section of a part of a second embodiment of a display device according to the invention.

The Figures are diagrammatic and not drawn to scale; corresponding parts generally have the same reference numerals.

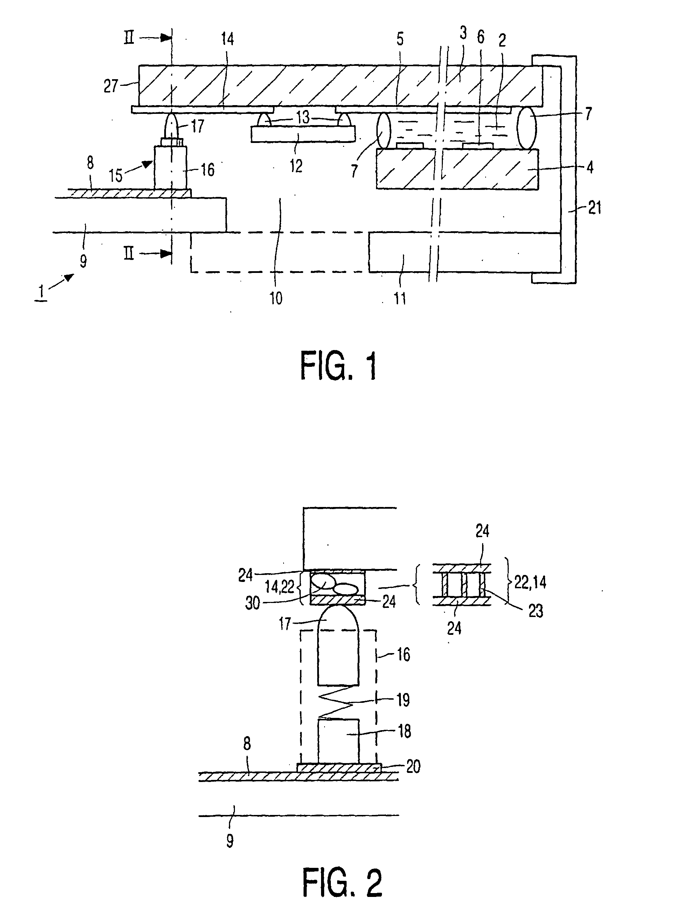

Fig. 1 is a diagrammatic cross-section of a part of a display device, in this embodiment a liquid crystal display device, comprising a liquid crystal cell 1 having, in this embodiment, a twisted nematic liquid crystal material 2 which is present between two transparent substrates 3, 4 of, for example, glass, provided with electrodes 5, 6. The device further comprises polarizers (not shown) whose direction of polarization is, for example, mutually perpendicularly crossed. The device also comprises orientation layers (not shown) which orient the liquid crystal material on the inner walls of the substrates, in this embodiment in such a way that the cell has a twist angle of 90 degrees. In this case, the liquid crystal material has a positive optical anisotropy and a positive dielectric anisotropy. If the electrodes 5, 6 are energized with an electric voltage, the molecules and hence the directors orient themselves to the field. The cell 1 is bounded by a cell wall or sealing edge 7.

The transparent electrodes 5, 6 of, for example, ITO (indium-tin oxide) which mutually cross each other perpendicularly in this embodiment and define pixels at the area of the crossings must be supplied with drive voltages. These may be applied externally, for example, via conducting tracks 8 on a support 9 such as a printed circuit board. In the device of Fig. 1, the support has an opening 10 in which, if necessary, an illumination source 11 may be arranged.

In the embodiment of Fig. 1, the electrodes 5 are supplied with drive voltages by means of a drive circuit (IC) 12 mounted on the first substrate 3. Contacting of the electrodes 5 (and also the electrodes 6 via methods which are conventional in the LCD technology) takes place via bumps 13. Other bumps 13 contact conductors 14 to be further described. Where in this application a "conductor pattern" on the substrate 3 is referred to, parts or the whole of conductors 14 are meant. In certain cases, the conductors 14 largely also consist of ITO, particularly when there are no ICs on the substrate 3. In other cases (in so-called active matrix LCDs) polysilicon tracks may be part of the conductor pattern.

As stated in the preamble, there is a great need of, for example, LCD screens (in this embodiment the assembly of the substrates 3, 4 with the liquid in between and the conductor tracks and drive circuits arranged on the substrates) to be supplied as one assembly, whereafter the final assembly takes place without any cumbersome steps. However, this should not be at the expense of a satisfactory contact which is necessary between the tracks 8 and the conductor pattern 5, 14.

According to the invention, the display device therefore comprises a metal-metal contact, in this embodiment a gold-gold contact, between a conductor track 14 and a connection pin, in this embodiment a resilient pin 15 (see also Fig. 2). Other suitable metals are silver and nickel.

In the embodiment of Fig. 2, use is made of an anisotropic conductor 14 for the conductor 14, in this embodiment a polyimide copper foil 22, with electrically conducting copper particles 30 which, upon compression, establish an electrically conducting connection between the two surface layers which are gold-plated on their surface (gold layers 24).

The conductor 14 may consist of a small metallized plate. Preferably, the material of this plate is also gold so that a gold-gold contact between the pin part 17 and the conductor 14 is obtained. Such contacts are very low-ohmic and very reliable, so that final assembly of the display device can take place without extra precautions. On the other hand, a different type of anisotropic conductor with conducting copper tracks 23 transverse to the foil may be used for the conductor 14, which copper tracks extend in one direction, in this embodiment in the direction of the pins 15 to the IC 12. In this embodiment, the foils are gold-plated on both sides throughout their surface so as to prevent oxidation of the copper (gold layers 24).

Since the foils 22 are gold-plated at the location of the contact with the pin 15, the contact between the conductor 13 and the pin 15 has all of the above-mentioned advantages of the gold-gold contact. In this embodiment, the foils are gold-plated on both sides throughout their surface (gold layers 24) so that an extra satisfactory conduction of the conductors 14 is ensured.

A cylindrical housing 16 of the pin 15 incorporates two conducting pin parts 17, 18, in this embodiment of gold, which are interconnected in an electrically conducting and mechanical manner by a resilient part 19 (within the housing 16). In this embodiment, the pin 15 has an electrically conducting surface 20 with the pin part 18 but this is not strictly necessary. The pin part 18 may also have a round or pointed end on the side facing the support 9.

In the final assembly, the assembly of the substrates 3, 4 with the liquid in between and the conductor tracks and drive circuits on the substrates is mounted together with the backlight 11, for example, by a clamping connection 21 or by molding in a plastic envelope under simultaneous pressure.

Since the resilient part 19 is compressed and subsequently the pressure on this resilient part is maintained by the clamp 21 or in a different way, the conductor 8 on the support 9 is connected in an electrically conducting manner to the conductor 14 on the substrate 3 via a pressure contact. Instead of this pogopin, other electrically conducting contact means may be used, such as anisotropically conducting foil contacts.

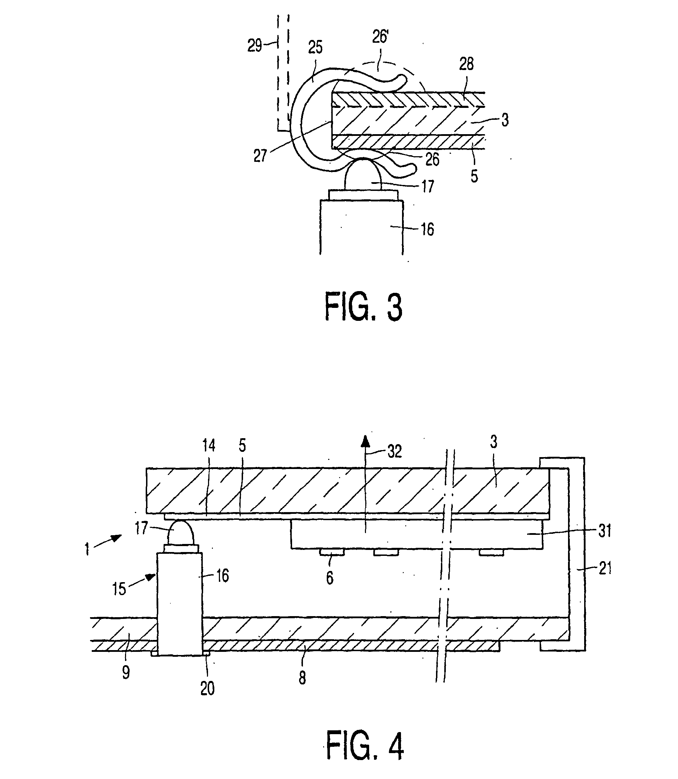

Fig. 3 shows a variant in which an ITO conductor 5 extends as far as (or proximate to) the edge 27 of the substrate 3. An electrically conducting U-shaped part 25, which is bent around the edge and secured by means ofUV glue 26, is now provided between the pin part 17 and the conductor 14. This results in a mechanically tighter construction. The conducting U-shaped part 25 (of a suitable metal such as gold, silver or nickel) may be provided by clamping, for example, by making use of suitable "glued-on pins" which, beyond the conductor part 15, comprise a pin part 29 used for further contacting in other applications. In this embodiment, the parts 29 are cut off after mounting.

Viewed transversely to the drawing, the device of Fig. 3 may also comprise a plurality of such conductor parts 25 which are accommodated in a connector housing. The conductor parts are, for example, punched from a suitable material having a satisfactory electrical conductance such as silver or locally gold-plated phosphor bronze and then molded in a synthetic material housing. The shape and dimension of the conductor parts and the connector housing are preferably chosen to be such that a clamping connection is obtained after the connector housing has been slid around the edge of the substrate 3. Consequently, a satisfactorily electrically conducting contact is obtained between the conductor track (the conductor) 14 and the conductor parts 25. To avoid contact resistances, a conducting paste may be provided, if necessary, at the contact areas between conductor tracks 14 and the conductor parts 25. The electric contact between the conductor part 14 and the conductor 8 may be realized, for example, by a mechanical clamping connection.

In the embodiments hitherto described, the conductor pattern 14 is present on the side of the substrate 3 facing the support 9. The layer 28 denoted by means of broken lines shows that a conductor pattern 28 may be alternatively contacted on the other side of the substrate when using the configuration shown in Fig. 3. In Fig. 1, the conductor 14 is shown as far as beyond the edge 27 of the substrate 3 so as to make clear that also a foil as described with reference to Fig. 2 can be bent around the substrate in order to enhance the mechanical rigidity in a similar manner or, if necessary, to contact conductors on the other surface of the substrate 3.

Fig. 4 shows a variant in which the display device on the substrate 3 has a layer 31 of an electroluminescent material in which poly-LED pixels are defined, for example, by means of the electrodes 5, 6. In this embodiment, the electrode 5 is connected in an electrically conducting manner to the pin part 17 via a small gold-plated plate 14 (or an anisotropic conductor as described above). The other contact of the resilient pin is now constituted by a conducting part 20 contacting the conductor 8 via soldering or by way of the resilient force. The pin 15 is adapted in such a way that the conductor 8 is present on the other side of the support remote from the pixels, but the construction of Fig. 1 is alternatively possible. The arrow 32 represents the light emitted by the poly-LEDs. Since no backlight is necessary in this case, the support 8 may extend under the layer 30 of electroluminescent material where it may comprise, for example, drive electronics (on one side or both sides of the support 9).

The invention is of course not limited to the embodiments shown, but many variations are possible within the scope of the invention. For example, instead of liquid crystal materials, other electro-optical materials such as electrophoretic or electrochromic materials may be used. The resilient part 19 may also be dispensed with in the resilient pin 15, provided that the distance between the pin parts 17, 18 is sufficiently small to ensure electric contact when the separate parts of the display device are being secured (molded, clicked tight).

In summary, the invention relates to connecting conductor tracks to a support and conductor tracks to a substrate of a display device via resilient conductors. Notably when using gold-gold contacts, very reliable pressure contacts are obtained.

The invention relates to each and every novel characteristic feature and each and every combination of characteristic features.

## Claims

1. A display device comprising a first substrate (3) having on said first substrate a conductor pattern (5, 14, 22) for connecting pixels in an electrically conducting manner, parts of which are connected in an electrically conducting manner to connection tracks (8) on a support (9), **characterized in that** the conductor pattern contacts an integrated circuit (12) provided on the first substrate (3) and the conducting connection between at least a part of the conductor pattern and a connection track comprises a metal-metal contact, in which each metal of the metal-metal contact is chosen from the group of gold, silver and nickel.

2. A display device as claimed in claim 1, **characterized in that** the metal-metal contact comprises a gold-gold contact.

3. A display device as claimed in claim 1, **characterized in that** the conducting connection between at least a part of the conductor pattern (5, 14, 22) and a connection track comprises a resilient conductor (15, 16, 17).

4. A display device as claimed in claim 3, **characterized in that** the conducting connection between the resilient conductor and the part of the conductor pattern comprises an anisotropically conducting foil (14, 22).

5. A display device as claimed in claim 1, **characterized in that** the conductor pattern is present on the support-facing side of the first substrate.

6. A display device as claimed in claim 1, **characterized in that** conductors (14, 22) associated with the conductor pattern extend as far as proximate to an edge (27) of the first substrate (3), a conductor part (25) associated with the electrically conducting connection between the connection track and the part of the conductor pattern enclosing said edge (27).

7. A display device as claimed in claim 1, **characterized in that** the display device comprises a second substrate (4) and an electro-optical material (2) between the two substrates, each being provided with picture electrodes (5, 6) which define pixels with the interpositioned electro-optical material, the first substrate being provided with the conductor pattern (15, 14, 22) beyond the part of the first substrate located opposite the second substrate.

8. A display device as claimed in claim 1, **characterized in that** the display device comprises an electroluminescent material (2).

9. A display device as claimed in claim 1, **characterized in that** at least a part of the conductor pattern (5, 14, 27) is connected in an electrically conducting manner to a connection track (8) on the side of the support (9) remote from the first substrate.

## Patentansprüche

1. Anzeigeeinrichtung, die ein erstes Substrat (3) mit einer Leiterbahnstruktur (5, 14, 22) auf dem genannten ersten Substrat zur Verbindung von Bildpunkten in einer elektrisch leitenden Weise umfasst, wobei Teile davon in einer elektrisch leitenden Weise mit Anschlussbahnen (8) auf einem Träger (9) verbunden sind, **dadurch gekennzeichnet, dass** die Leiterbahnstruktur eine integrierte Schaltung (12) kontaktiert, die auf dem ersten Substrat (3) angebracht ist, und die leitende Verbindung zwischen mindestens einem Teil der Leiterbahnstruktur und einer Anschlussbahn einen Metall-Metall-Kontakt umfasst, wobei jedes Metall des Metall-Metall-Kontakts aus der Gruppe Gold, Silber und Nickel gewählt ist.

2. Anzeigeeinrichtung nach Anspruch 1, **dadurch gekennzeichnet, dass** der Metall-Metall-Kontakt einen Gold-Gold-Kontakt umfasst.

3. Anzeigeeinrichtung nach Anspruch 1, **dadurch gekennzeichnet, dass** die leitende Verbindung zwischen mindestens einem Teil der Leiterbahnstruktur (5, 14, 22) und einer Anschlussbahn einen federnden Leiter (15, 16, 17) umfasst.

4. Anzeigeeinrichtung nach Anspruch 3, **dadurch gekennzeichnet, dass** die leitende Verbindung zwischen dem federnden Leiter und dem Teil der Leiterbahnstruktur eine anisotrop leitende Folie (14, 22) umfasst.

5. Anzeigeeinrichtung nach Anspruch 1, **dadurch gekennzeichnet, dass** sich die Leiterbahnstruktur auf der dem Träger zugewandten Seite des ersten Substrats befindet.

6. Anzeigeeinrichtung nach Anspruch 1, **dadurch gekennzeichnet, dass** sich die zu der Leiterbahnstruktur gehörenden Leiter (14, 22) bis nahe an einen Rand (27) des ersten Substrats (3) ausdehnen, wobei ein zu der elektrisch leitenden Verbindung zwischen der Anschlussbahn und dem Teil der Leiterbahnstruktur gehörendes Leiterteil (25) den genannten Rand (27) einschließt.

7. Anzeigeeinrichtung nach Anspruch 1, **dadurch gekennzeichnet, dass** die Anzeigeeinrichtung ein zweites Substrat (4) und ein elektrooptisches Material (2) zwischen den zwei Substraten umfasst, wobei jedes mit Bildelektroden (5, 6), die mit dem dazwischen positionierten elektrooptischen Material Bildpunkte definieren, versehen ist, wobei das erste Substrat außerhalb des Teils des ersten Substrats, der sich gegenüber dem zweiten Substrat befindet, mit der Leiterbahnstruktur (5, 14, 22) versehen ist.

8. Anzeigeeinrichtung nach Anspruch 1, **dadurch gekennzeichnet, dass** die Anzeigeeinrichtung ein elektrolumineszentes Material (2) umfasst.

9. Anzeigeeinrichtung nach Anspruch 1, **dadurch gekennzeichnet, dass** mindestens ein Teil der Leiterbahnstruktur (5, 14, 22) in elektrisch leitender Weise mit einer Anschlussbahn (8) auf der vom ersten Substrat abgewandten Seite des Trägers (9) verbunden ist.

## Revendications

1. Dispositif d'affichage comprenant un premier substrat (3) présentant sur ledit premier substrat un motif conducteur (5, 14, 22) pour connecter des pixels d'une manière conductrice de l'électricité, dont des parties sont connectées d'une manière conductrice de l'électricité à des pistes de connexion (8) sur un support (9), **caractérisé en ce que** le motif conducteur entre en contact avec un circuit intégré (12) prévu sur le premier substrat (3) et la connexion conductrice entre au moins une partie du motif conducteur et une piste de connexion comprend un contact métal-métal, dans lequel chaque métal du contact métal-métal est sélectionné parmi le groupe comprenant l'or, l'argent et le nickel.

2. Dispositif d'affichage suivant la revendication 1, **caractérisé en ce que** le contact métal-métal est un contact or-or.

3. Dispositif d'affichage suivant la revendication 1, **caractérisé en ce que** la connexion conductrice entre au moins une partie du motif conducteur (5, 14, 22) et une piste de connexion comprend un conducteur élastique (15, 16, 17).

4. Dispositif d'affichage suivant la revendication 3, **caractérisé en ce que** la connexion conductrice entre le conducteur élastique et la partie du motif conducteur comprend une feuille conductrice de manière anisotrope (14, 22).

5. Dispositif d'affichage suivant la revendication 1, **caractérisé en ce que** le motif conducteur est présent sur le côté faisant face au support du premier substrat.

6. Dispositif d'affichage suivant la revendication 1, **caractérisé en ce que** des conducteurs (14, 22) associés au motif conducteur s'étendent jusqu'à proximité d'un bord (27) du premier substrat (3), une partie de conducteur (25) associée à la connexion conductrice de l'électricité entre la piste de connexion et la partie du motif conducteur enfermant ledit bord (27).

7. Dispositif d'affichage suivant la revendication 1, **caractérisé en ce que** le dispositif d'affichage comprend un deuxième substrat (4) et un matériau électro-optique (2) entre les deux substrats, chacun étant muni d'électrodes d'image (5, 6) qui définissent des pixels avec le matériau électro-optique intercalé, le premier substrat étant doté du motif conducteur (15, 14, 22) au-delà de la partie du premier substrat située à l'opposé du deuxième substrat.

8. Dispositif d'affichage suivant la revendication 1, **caractérisé en ce que** le dispositif d'affichage comprend un matériau électroluminescent (2).

9. Dispositif d'affichage suivant la revendication 1, **caractérisé en ce qu'**au moins une partie du motif conducteur (5, 14, 27) est connecté d'une manière conductrice de l'électricité à une piste de connexion (8) sur le côté du support (9) éloigné du premier substrat.
